# EUROPEAN PATENT APPLICATION

(11) **EP 4 044 250 A1**
(43) Date of publication of application: **17.08.2022**
(21) Application number: 22153997.6
(22) Date of filing: 28.01.2022
(51) Int. Cl.: H01L 29/739, H01L 29/40, H01L 23/00, H01L 29/423

(54) **INSULATED GATE BIPOLAR FIELD-EFFECT TRANSISTOR, GROUP, AND POWER CONVERTER**

(30) Priority: 10.02.2021 CN 202110183813
(71) Applicant: Huawei Technologies Co., Ltd., Longgang District Shenzhen, Guangdong 518129 (CN)
(72) Inventor: DAI, Loucheng, Shenzhen, Guangdong, 518129 (CN); YANG, Wentao, Shenzhen, Guangdong, 518129 (CN); ZUO, Huiling, Shenzhen, Guangdong, 518129 (CN); WANG, Kang, Shenzhen, Guangdong, 518129 (CN); HOU, Zhaozheng, Shenzhen, Guangdong, 518129 (CN); HUANG, Boning, Shenzhen, Guangdong, 518129 (CN)
(74) Representative: MERH-IP Matias Erny Reichl Hoffmann Patentanwälte PartG mbB

(57) **Abstract**

This application discloses an insulated gate bipolar field-effect transistor IGBT, a group, and a power converter. The IGBT includes a semiconductor chip, a gate pin disposed around the semiconductor chip, and an emitter region and n gate regions that are disposed on the semiconductor chip, where n is an integer greater than or equal to 2; a gate regions in the n gate regions are connected to the gate pin, where a is greater than or equal to 1 and less than or equal to n; when there is a different quantity a of gate regions connected to the gate pin, the IGBT is correspondingly applicable to a scenario in which there is a different switching frequency and loss; and n-a gate regions in the n gate regions are connected to the emitter region. A conductive channel is formed around all gate regions connected to the gate pin, and an injected electron from an emitter passes through the conductive channel. A quantity of conductive channels corresponding to the injected electron from the emitter is increased, so that an on-state voltage drop between a collector and the emitter is reduced, and a conduction loss of the IGBT is reduced. An IGBT with a small conduction loss may be applied to a scenario in which there is a low switching frequency.

## Description

### TECHNICAL FIELD

This application relates to the technical field of power electronic devices, and in particular, to an insulated gate bipolar field-effect transistor, a group, and a power converter.

### BACKGROUND

An insulated gate bipolar field-effect transistor (IGBT, Insulated Gate Bipolar Transistor) is a composite fully controlled voltage-driven power semiconductor device including a bipolar junction transistor (BJT, Bipolar Junction Transistor) and a metal-oxide-semiconductor field-effect transistor (MOSFET, Metal-Oxide-Semiconductor Field-Effect Transistor). The BJT has a small saturation voltage drop and a high current carrying capacity, but has a large drive current. The MOSFET has a very low drive power and a high switching speed, but has a large on-state voltage drop and a low current carrying capacity. The IGBT integrates advantages of the MOSFET and the BJT. To be specific, the IGBT has advantages such as high input impedance, a high switching speed, good thermal stability, a simple drive circuit, a small drive current, a small saturation voltage drop, a high withstand voltage, and a large withstand current. Therefore, currently, the IGBT is widely applied to the power electronic field.

However, an IGBT in the conventional technology has poor application flexibility due to a complex process or a complex drive circuit.

### SUMMARY

To resolve the foregoing technical problem, this application provides an IGBT, an IGBT group, and a power converter, which can adapt to different application scenarios, and has high flexibility.

An embodiment of this application provides an insulated gate bipolar field-effect transistor IGBT, including a semiconductor chip, a gate pin disposed around the semiconductor chip, and an emitter region and n gate regions that are disposed on the semiconductor chip, where n is an integer greater than or equal to 2. In other words, the IGBT includes a plurality of gate regions. Specifically, a gate regions may be selected from the n gate regions based on an actual requirement, and then are connected to the gate pin, where a is greater than or equal to 1 and less than or equal to n; n-a remaining gate regions in the n gate regions are connected to the emitter region; and when there is a different quantity a of gate regions connected to the gate pin, the IGBT is correspondingly applicable to a scenario in which there is a different switching frequency and loss. For example, a smaller value of a is selected when there is a higher switching frequency; and a larger value of a is selected when there is a lower switching frequency. A loss of the IGBT is divided into a switching loss and a conduction loss. An IGBT with a small switching loss is applicable to a scenario in which there is a high switching frequency, and an IGBT with a small conduction loss is applicable to a scenario in which there is a low switching frequency. The IGBT provided in this embodiment of this application includes a plurality of gate regions. In other words, a may have a plurality of values. Therefore, the IGBT may be applied more flexibly, and different values of a may be selected based on different application scenarios.

The semiconductor chip of the IGBT provided in this embodiment of this application includes a plurality of gate regions, at least one of the plurality of gate regions may be connected to the gate pin, and the other gate regions in the plurality of gate regions may be connected to the emitter region on the semiconductor chip. Because the IGBT provided in this embodiment of this application includes a plurality of gate regions, a quantity of gate regions connected to the gate pin of the semiconductor chip may be selected based on an actual requirement. Electrical performance of the IGBT varies with the quantity of gate regions connected to the gate pin. For the IGBT having the plurality of gate regions, when more gate regions are connected to the gate pin, a conductive channel is formed around all gate regions connected to the gate pin, and an injected electron from an emitter passes through the conductive channel. In other words, a quantity of conductive channels corresponding to the injected electron from the emitter is increased, so that an on-state voltage drop between a collector and the emitter is reduced. Therefore, a conduction loss of the IGBT can be reduced. An IGBT with a small conduction loss may be applied to a scenario in which there is a low switching frequency. On the contrary, when a small quantity of gate regions are connected to the gate pin, a smaller quantity of conductive channels are formed. A smaller quantity of conductive channels through which an injected electron passes leads to lower efficiency of injecting an electron by the emitter. Consequently, a corresponding on-state voltage drop between a collector and an emitter becomes larger. Therefore, the switching loss of the IGBT is reduced, but the conduction loss is increased. This type of IGBT is applicable to a scenario in which a high switching frequency is required.

The a gate regions may be connected to the gate pin in the following two implementations:

### Implementation 1:

The a gate regions are short-circuited together and are connected to the gate pin; and the n-a gate regions are short-circuited together and are connected to the emitter region. An advantage of this implementation in which a plurality of gate regions are short-circuited together and then are connected to the gate pin is to avoid too many leads and to provide a simple process. In addition, less signal interference is generated when there is a smaller quantity of leads and a shorter lead. For example, parasitic capacitance and parasitic inductance are reduced.

### Implementation 2:

The a gate regions are separately connected to the gate pin; and the n-a gate regions are separately connected to the emitter region.

A switching frequency of the IGBT is high in some scenarios, for example, a high-frequency scenario, and a switching frequency of the IGBT is low in some scenarios, for example, a medium-frequency scenario and a low-frequency scenario. For the IGBT including the plurality of gate regions, a selection principle of a is as follows: The conduction loss of the IGBT is positively correlated with a, the switching loss of the IGBT is positively correlated with n-a, and the switching frequency of the IGBT is negatively correlated with a. A positive correlation means that a larger value of a indicates a higher conduction loss of the IGBT. A negative correlation means that a larger value of a indicates that the IGBT is applicable to a scenario in which there is a lower switching frequency.

The following separately describes specific implementations in which the IGBT includes two gate regions, three gate regions, and four gate regions.

In a possible implementation, the n gate regions include the following two gate regions: a first gate region and a second gate region; and the first gate region and the second gate region are short-circuited together and are connected to the gate pin; or
the first gate region is connected to the gate pin, and the second gate region is connected to the emitter region.

In a possible implementation, the n gate regions include the following three gate regions: a first gate region, a second gate region, and a third gate region; and the first gate region, the second gate region, and the third gate region are short-circuited together and are connected to the gate pin; or
two of the first gate region, the second gate region, and the third gate region are short-circuited together and are connected to the gate pin, and the other gate region is connected to the emitter region; or
two of the first gate region, the second gate region, and the third gate region are short-circuited together and are connected to the emitter region, and the other gate region is connected to the gate pin.

In a possible implementation, the n gate regions include the following four gate regions: a first gate region, a second gate region, a third gate region, and a fourth gate region; and
the first gate region, the second gate region, the third gate region, and the fourth gate region are short-circuited together and are connected to the gate pin; or
three of the first gate region, the second gate region, the third gate region, and the fourth gate region are short-circuited together and are connected to the gate pin, and the other gate region is connected to the emitter region; or
two of the first gate region, the second gate region, the third gate region, and the fourth gate region are short-circuited together and are connected to the gate pin, and the other two gate regions are connected to the emitter region; or
three of the first gate region, the second gate region, the third gate region, and the fourth gate region are short-circuited together and are connected to the emitter region, and the other gate region is connected to the gate pin.

When the IGBT includes the plurality of gate regions, and the plurality of gate regions are short-circuited together and are connected to the gate pin, a specific short-circuiting manner is not limited in this embodiment of this application. For example, adjacent gate regions may be sequentially short-circuited, or the plurality of gate regions may be short-circuited in a crossing manner.

Based on the IGBT provided in the foregoing embodiment, an embodiment of this application further provides an IGBT group, namely, an IGBT module, including a semiconductor chip. The semiconductor chip includes a plurality of IGBTs; a gate pin, an emitter pin, and a collector pin of each IGBT are disposed around the semiconductor chip; an emitter region and a gate region of each IGBT are disposed on the semiconductor chip, and at least one IGBT includes a plurality of gate regions; at least one of the plurality of gate regions is connected to a gate pin of a corresponding IGBT; and the other gate regions in the plurality of gate regions are connected to an emitter region of the corresponding IGBT. Whether each IGBT tube in the IGBT group includes a plurality of gate regions is not limited. At least one IGBT may include a plurality of gate regions, or the plurality of IGBTs each may include a plurality of gate regions. In addition, for more flexible use, each IGBT in the IGBT group may include a plurality of gate regions.

The semiconductor chip of the IGBT includes a plurality of gate regions, at least one of the plurality of gate regions may be connected to the gate pin, and the other gate regions in the plurality of gate regions may be connected to the emitter region on the semiconductor chip. Because the IGBT provided in this embodiment of this application includes a plurality of gate regions, a quantity of gate regions connected to the gate pin of the semiconductor chip may be selected based on an actual requirement. Electrical performance of the IGBT varies with the quantity of gate regions connected to the gate pin. For the IGBT having the plurality of gate regions, when more gate regions are connected to the gate pin, a conductive channel is formed around all gate regions connected to the gate pin, and an injected electron from an emitter passes through the conductive channel. In other words, a quantity of conductive channels corresponding to the injected electron from the emitter is increased, so that an on-state voltage drop between a collector and the emitter is reduced. Therefore, a conduction loss of the IGBT can be reduced. An IGBT with a small conduction loss may be applied to a scenario in which there is a low switching frequency. On the contrary, when a small quantity of gate regions are connected to the gate pin, a smaller quantity of conductive channels are formed. A smaller quantity of conductive channels through which an injected electron passes leads to lower efficiency of injecting an electron by the emitter. Consequently, a corresponding on-state voltage drop between a collector and the emitter becomes larger. Therefore, a switching loss of the IGBT is reduced, but the conduction loss is increased. This type of IGBT is applicable to a scenario in which a high switching frequency is required.

In a possible implementation, each IGBT includes a plurality of gate regions.

In a possible implementation, for a first IGBT including a plurality of gate regions, the plurality of gate regions are n gate regions, where n is an integer greater than or equal to 2; and a gate regions are short-circuited together and are connected to a gate pin of the first IGBT, and b gate regions are short-circuited together and are connected to an emitter region of the first IGBT, where a + b = n.

In a possible implementation, for a first IGBT including a plurality of gate regions, the plurality of gate regions are n gate regions, where n is an integer greater than or equal to 2; and a gate regions are separately connected to a gate pin of the first IGBT, and b gate regions are separately connected to an emitter region of the first IGBT, where a + b = n.

In a possible implementation, a conduction loss of the first IGBT is positively correlated with a, and a switching loss of the first IGBT is positively correlated with b.

Based on the IGBT or the IGBT group provided in the foregoing embodiments, an embodiment of this application further provides a power converter, including the foregoing described IGBT or including the foregoing described IGBT group. A specific type of the power converter is not limited in this application. For example, the power converter may be a direct current/direct current converter, a direct current/alternating current converter, or an alternating current/direct current converter. An application scenario of the power converter is not limited either. For example, the power converter may be a charging pile, an inverter in the power supply field, or an inverter in the photovoltaic field.

The IGBT or the IGBT group included in the power converter includes a plurality of gate regions, at least one of the plurality of gate regions is connected to a gate pin, and the other gate regions in the plurality of gate regions are connected to an emitter region. Because the IGBT provided in this embodiment of this application includes a plurality of gate regions, a quantity of gate regions connected to a gate pin of an IGBT chip may be selected based on an actual requirement. Electrical performance of the IGBT varies with the quantity of gate regions connected to the gate pin. For the IGBT having the plurality of gate regions, when more gate regions are connected to the gate pin, a conductive channel is formed around all gate regions connected to the gate pin, and an injected electron from an emitter passes through the conductive channel. In other words, a quantity of conductive channels corresponding to the injected electron from the emitter is increased, so that an on-state voltage drop between a collector and the emitter is reduced. Therefore, a conduction loss of the IGBT can be reduced. An IGBT with a small conduction loss may be applied to a scenario in which there is a low switching frequency. On the contrary, when a small quantity of gate regions are connected to the gate pin, a smaller quantity of conductive channels are formed. A smaller quantity of conductive channels through which an injected electron passes leads to lower efficiency of injecting an electron by the emitter. Consequently, a corresponding on-state voltage drop between a collector and the emitter becomes larger. Therefore, the switching loss of the IGBT is reduced, but the conduction loss is increased. This type of IGBT is applicable to a scenario in which a high switching frequency is required. Therefore, a structure of the IGBT in the power converter can be selected based on a specific application scenario.

This application has at least the following advantages:

The semiconductor chip of the IGBT provided in the embodiments of this application includes a plurality of gate regions, at least one of the plurality of gate regions may be connected to the gate pin, and the other gate regions in the plurality of gate regions may be connected to the emitter region on the semiconductor chip. Because the IGBT provided in the embodiments of this application includes a plurality of gate regions, a quantity of gate regions connected to the gate pin of the semiconductor chip may be selected based on an actual requirement. The electrical performance of the IGBT varies with the quantity of gate regions connected to the gate pin. For the IGBT having the plurality of gate regions, when more gate regions are connected to the gate pin, a conductive channel is formed around all gate regions connected to the gate pin, and an injected electron from an emitter passes through the conductive channel. In other words, a quantity of conductive channels corresponding to the injected electron from the emitter is increased, so that an on-state voltage drop between a collector and the emitter is reduced. Therefore, a conduction loss of the IGBT can be reduced. An IGBT with a small conduction loss may be applied to a scenario in which there is a low switching frequency. On the contrary, when a small quantity of gate regions are connected to the gate pin, a smaller quantity of conductive channels are formed. A smaller quantity of conductive channels through which an injected electron passes leads to lower efficiency of injecting an electron by an emitter. Consequently, a corresponding on-state voltage drop between a collector and the emitter becomes larger. Therefore, a switching loss of the IGBT is reduced, but a conduction loss is increased. This type of IGBT is applicable to a scenario in which a high switching frequency is required.

### BRIEF DESCRIPTION OF DRAWINGS

FIG. 1 is a schematic diagram of an I-type three-level inverter according to an embodiment of this application;
FIG. 2 is a schematic diagram of a layout of an IGBT;
FIG. 3 is a schematic diagram of a layout of an IGBT according to an embodiment of this application;
FIG. 4A is a schematic diagram of a layout of two gate regions included in an IGBT according to an embodiment of this application;
FIG. 4B is a schematic diagram of a cell structure corresponding to FIG. 4A;
FIG. 4C is a schematic diagram of a connection between two gate regions included in a single IGBT according to an embodiment of this application;
FIG. 4D is a schematic diagram of a connection between two gate regions included in another single IGBT according to an embodiment of this application;
FIG. 4E is a schematic diagram of a connection between two gate regions included in an IGBT group according to an embodiment of this application;
FIG. 4F is a schematic diagram of a connection between two gate regions included in another IGBT group according to an embodiment of this application;
FIG. 5A is a schematic diagram of a layout of three gate regions included in an IGBT according to an embodiment of this application;
FIG. 5B is a schematic diagram of a cell structure corresponding to FIG. 5A;
FIG. 5C is a schematic diagram of a connection among three gate regions included in an IGBT according to an embodiment of this application;
FIG. 5D is a schematic diagram of a connection among three gate regions included in another IGBT according to an embodiment of this application;
FIG. 5E is a schematic diagram of a connection among three gate regions included in still another IGBT according to an embodiment of this application;
FIG. 6A is a schematic diagram of a layout of four gate regions included in an IGBT according to an embodiment of this application;
FIG. 6B is a schematic diagram of a cell structure corresponding to FIG. 6A;
FIG. 6C is a schematic diagram of a connection among four gate regions included in an IGBT according to an embodiment of this application;
FIG. 6D is a schematic diagram of a connection among four gate regions included in another IGBT according to an embodiment of this application;
FIG. 6E is a schematic diagram of a connection among four gate regions included in still another IGBT according to an embodiment of this application;
FIG. 6F is a schematic diagram of a connection among four gate regions included in yet another IGBT according to an embodiment of this application; and
FIG. 6G is a schematic diagram of a connection among four gate regions included in another IGBT according to an embodiment of this application.

### DESCRIPTION OF EMBODIMENTS

In the following description, terms such as "first" and "second" are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise specified, "a plurality of" means two or more than two.

In addition, in this application, directional terms such as "up" and "down" may include but are not limited to directions of schematically placed components in relative accompanying drawings. It should be understood that these directional terms may be relative concepts. The directional terms are used for relative description and clarification, and may vary correspondingly based on a change in an orientation in which the component is placed in the accompanying drawings.

In this application, unless otherwise expressly specified and limited, the term "connection" should be understood in a broad sense. For example, "connection" may be a fixed connection, a detachable connection or an integral connection; and may be a direct connection or an indirect connection by using an intermediate medium. In addition, the term "coupled" may be a manner of implementing an electrical connection for signal transmission. The "coupling" may be a direct electrical connection, or may be an indirect electrical connection through an intermediate medium.

An embodiment of this application relates to an IGBT. To make a person skilled in the art better understand the technical solutions provided in this embodiment of this application, the following first describes an application scenario of the IGBT provided in this embodiment of this application. As a semiconductor power device, the IGBT is very widely applied to the power electronic field, and especially to a power conversion circuit. For example, the IGBT may be applied to a power factor correction (PFC, Power Factor Correction) circuit of an uninterruptible power supply (UPS, Uninterruptible Power Supply), an inverter, or a direct current/direct current (DC/DC, Direct Circuit/Direct Circuit) conversion circuit, for example, a Boost circuit.

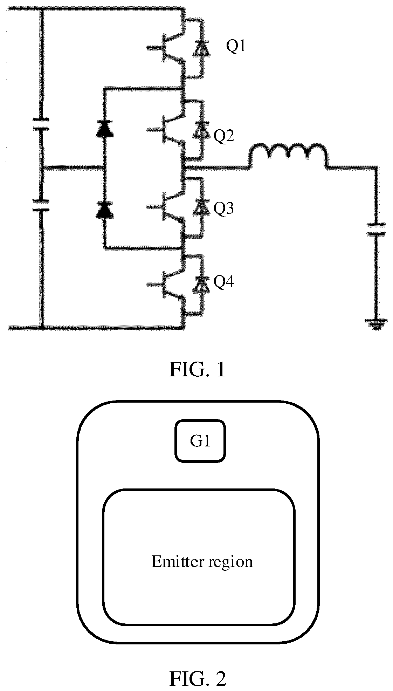

FIG. 1 is a schematic diagram of an I-type three-level inverter according to an embodiment of this application.

An application scenario of the I-type three-level inverter is not limited in this embodiment of this application, and for example, may be applied to a UPS.

It can be learned from FIG. 1 that Q1 to Q4 each are an IGBT device. Gate electrodes of Q1 to Q4 may receive a driving pulse signal sent by a controller. In other words, the controller controls switching states of Q1 to Q4 by using the driving pulse signal, so that the inverter completes power conversion.

When an IGBT is applied to different application scenarios, there are different requirements on a working frequency and power consumption of the IGBT in different application scenarios. If the IGBT is packaged in a form of a single gate electrode, FIG. 2 is a schematic diagram of a layout of an IGBT.

The IGBT shown in FIG. 2 includes only one gate region G1, and the IGBT having one gate region G1 corresponds to a single working frequency, and cannot be flexibly applied to various scenarios. For example, a high switching frequency of the IGBT is required in some working scenarios, and a low switching frequency of the IGBT is required in some working scenarios. In an application scenario in which there is a high switching frequency, in other words, a quantity of switching actions of the IGBT is high in a unit time, a small switching loss of the IGBT is required. In an application scenario in which there is a low switching frequency, in other words, a quantity of switching actions of the IGBT is low in a unit time, a small conduction loss of the IGBT is required. The IGBT including only one gate region G1 cannot be applicable for many different scenarios.

To resolve the foregoing technical problem, an embodiment of this application provides an IGBT, including a plurality of gate regions. At least one of the plurality of gate regions is connected to a gate pin, and the other gate regions in the plurality of gate regions are connected to an emitter region. Because the IGBT provided in this embodiment of this application includes a plurality of gate regions, a quantity of gate regions connected to a gate pin of an IGBT chip may be selected based on an actual requirement. Electrical performance of the IGBT varies with the quantity of gate regions connected to the gate pin. For the IGBT having the plurality of gate regions, when more gate regions are connected to the gate pin, a conductive channel is formed around all gate regions connected to the gate pin, and an injected electron from an emitter passes through the conductive channel. In other words, a quantity of conductive channels through which an emitter injects an electron into a collector is increased, so that an on-state voltage drop between the collector and the emitter is reduced. Therefore, a conduction loss of the IGBT can be reduced. An IGBT with a small conduction loss may be applied to a scenario in which there is a low switching frequency. On the contrary, when a small quantity of gate regions are connected to the gate pin, a smaller quantity of conductive channels are formed. A smaller quantity of conductive channels through which an injected electron passes leads to lower efficiency of injecting an electron by the emitter. Consequently, a corresponding on-state voltage drop between a collector and the emitter becomes larger. Therefore, a switching loss of the IGBT is reduced, but a conduction loss is increased. This type of IGBT is applicable to a scenario in which a high switching frequency is required.

It should be understood that, in a semiconductor power device, one IGBT may be packaged, or a plurality of IGBTs, namely, an IGBT group, may be packaged. Therefore, an embodiment of this application further provides an IGBT group, including a semiconductor chip. The semiconductor chip includes a plurality of IGBTs; a gate pin, an emitter pin, and a collector pin of each IGBT are disposed around the semiconductor chip; an emitter region and a gate region of each IGBT are disposed on the semiconductor chip; and at least one IGBT includes a plurality of gate regions, in other words, the plurality of IGBTs each may include a plurality of gate regions, or only one IGBT in the IGBT group may include a plurality of gate regions. This is not specifically limited in this embodiment of this application. At least one of the plurality of gate regions is connected to a gate pin of a corresponding IGBT, and the other gate regions in the plurality of gate regions are connected to an emitter region of the corresponding IGBT. The semiconductor power device includes one IGBT, or includes a plurality of IGBTs. Specifically, there is a different wire seating layout.

The following first describes a case in which one semiconductor power device includes one IGBT and a case in which one semiconductor power device includes a single IGBT tube in this embodiment of this application.

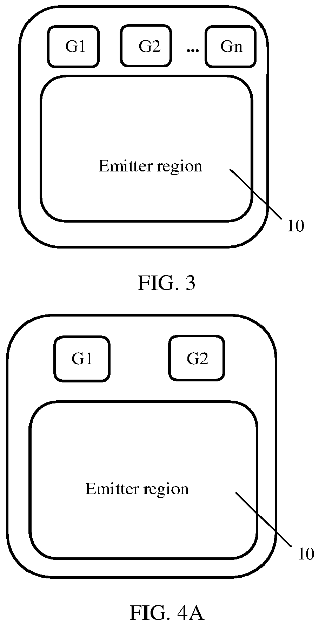

FIG. 3 is a schematic diagram of a layout of an IGBT according to an embodiment of this application.

The IGBT provided in this embodiment of this application includes a semiconductor chip, a gate pin disposed around the semiconductor chip, and an emitter region and n gate regions that are disposed on the semiconductor chip, where n is an integer greater than or equal to 2; a gate regions in the n gate regions are connected to the gate pin, where a is greater than or equal to 1 and less than or equal to n; when there is a different quantity a of gate regions connected to the gate pin, the IGBT is correspondingly applicable to a scenario in which there is a different switching frequency and loss; and n-a gate regions in the n gate regions are connected to the emitter region. A switching frequency of the IGBT is high in some scenarios, for example, a high-frequency scenario, and a switching frequency of the IGBT is low in some scenarios, for example, a medium-frequency scenario and a low-frequency scenario. However, when there are different switching frequencies, there are different requirements for a switching loss and a conduction loss of the IGBT. Therefore, a specific value of a may be selected based on a specific application scenario of the IGBT. For example, the conduction loss of the IGBT is positively correlated with a, the switching loss of the IGBT is positively correlated with n-a, and a switching frequency of the IGBT is negatively correlated with a. A positive correlation means that a larger value of a indicates a higher conduction loss of the IGBT. A negative correlation means that a larger value of a indicates that the IGBT is applicable to a scenario in which there is a lower switching frequency.

The IGBT provided in this embodiment of this application includes a semiconductor chip 20.

A gate pin, an emitter pin, and a collector pin that are disposed around the semiconductor chip 20, an emitter region 10 and a plurality of gate regions are disposed on the semiconductor chip 20, and the plurality of gate regions are G1, G2, ..., and Gn. A specific value of n is not limited in this embodiment of this application, and n is an integer that may be greater than or equal to 2, for example, 3, 4, or 5, or even a larger integer.

At least one of the plurality of gate regions (G1, G2, ..., and Gn) is connected to a gate pin G, and a connection wire is not shown in the figure.

The other gate regions in the plurality of gate regions are connected to the emitter region 10, and a connection wire is not shown in the figure. The emitter region 10 is actually an emitter wire seating region.

A person skilled in the art may select a specific quantity of gate regions connected to the gate pin based on an actual application scenario of the IGBT. For example, if the application scenario of the IGBT is a scenario in which there is a high switching frequency, a low switching loss of the IGBT is required, and a small quantity of gate regions need to be selected, and then are connected to the gate pin. On the contrary, if the IGBT is applied to a scenario in which there is a low switching frequency, a low conduction loss of the IGBT is required, and a large quantity of gate regions need to be selected, and then are connected to the gate pin.

The following specifically describes two different connection relationships between the plurality of gate regions and each of the gate pin and the emitter region. Herein, a gate regions in the n gate regions are connected to the gate pin, and b gate regions are connected to the emitter region. Herein, a + b = n, a is an integer greater than or equal to 1, and n is an integer greater than or equal to 1. Therefore, b = n - a.

### First connection manner:

The a gate regions are short-circuited together and are connected to the gate pin. To be specific, the a gate regions are short-circuited together, and then are connected to the gate pin through a wire. The b gate regions are short-circuited together and are connected to the emitter region. To be specific, the b gate regions are short-circuited together, and then are connected to the gate pin through a wire. Advantages of this manner are as follows: There is a small quantity of connection wires between the gate region and the gate pin, and a manufacturing process is simple. In addition, the connection wire is usually conductive metal, and it is more likely to form parasitic capacitance and parasitic inductance when there are more metal wires. Therefore, fewer connection wires cause lower interference.

### Second connection manner:

The a gate regions are separately connected to the gate pin. To be specific, the a gate regions are separately and independently connected to the gate pin. In other words, the gate pin needs to be separately connected to the a gate regions. The b gate regions are separately connected to the emitter region. To be specific, the emitter region needs to be separately connected to the b gate regions by using b wires.

It can be learned from the foregoing analysis that the IGBT includes the n gate regions, the a gate regions are connected to the gate pin, and the b gate regions are connected to the emitter region. Therefore, the conduction loss of the IGBT is positively correlated with a, and the switching loss of the IGBT is positively correlated with b.

To make a person skilled in the art better understand the technical solution provided in this embodiment of this application, the following separately describes implementations in which the IGBT includes two gate regions, three gate regions, and four gate regions.

FIG. 4A is a schematic diagram of a layout of two gate regions included in an IGBT according to an embodiment of this application.

In this embodiment, that the IGBT includes two gate regions is used as an example for description. To be specific, the plurality of gate regions include the following two gate regions: a first gate region G1 and a second gate region G2, namely, two gate pads.

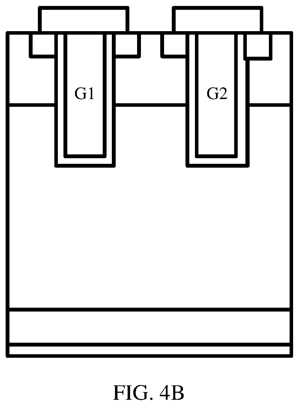

FIG. 4B is a schematic diagram of a cell structure corresponding to FIG. 4A.

In this embodiment of this application, that the IGBT is of a trench gate IGBT structure is used as an example. FIG. 4B is a schematic diagram of a cell of a trench gate IGBT including two gate regions G1 and G2.

The following describes a specific wire seating manner with reference to an example in which a single IGBT includes two gate regions.

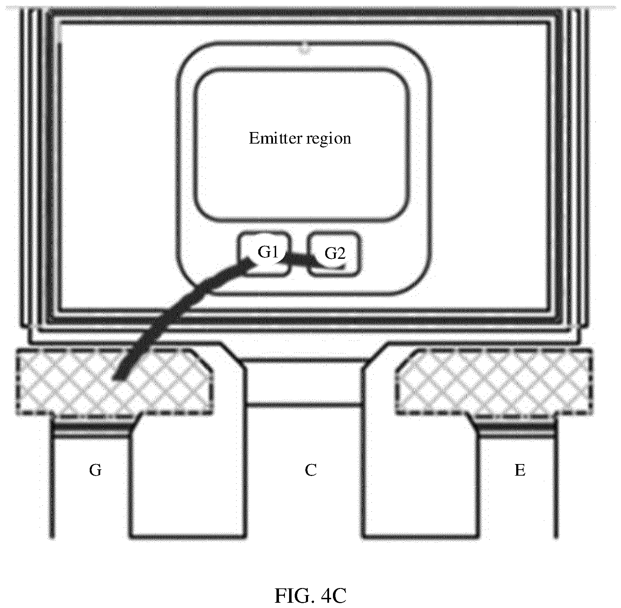

FIG. 4C is a schematic diagram of a connection between two gate regions included in a single IGBT according to an embodiment of this application.

The following describes an implementation in which the two gate regions, to be specific, the first gate region G1 and the second gate region G2, each are connected to the gate pin. In other words, no gate region is connected to the emitter region 10.

In a specific implementation, the first gate region G1 and the second gate region G2 are short-circuited together and are connected to the gate pin G. It can be learned from the figure that, when the first gate region G1 and the second gate region G2 are short-circuited together and then are connected to the gate pin G, there is a small quantity of connection wires, to avoid complex wiring caused when too many wires are used to connect the gate pin G. In a specific implementation, the first gate region G1 and the second gate region G2 may be short-circuited together through a metal interconnection.

For example, when the gate pin G is connected to a driving pulse signal of +15 V, the first gate region G1 and the second gate region G2 simultaneously work (to be specific, G1 = G2 = 15 V), and a conductive channel through which an injected electron passes is formed around each of the first gate region G1 and the second gate region G2. Therefore, the injected electron from the emitter can be injected into the collector through the conductive channel around the first gate region G1 and the second gate region G2. Therefore, an on-state voltage drop Vcesat between the collector and the emitter is reduced. When Vcesat is reduced, the conduction loss of the IGBT is correspondingly reduced. Therefore, this type of IGBT can be applied to a scenario in which there is a low switching frequency. Because there is a small quantity of switching times, a period of conduction time of the IGBT is long, and the conduction loss is small. Therefore, overall power consumption is reduced.

In addition, there may be another implementation: The first gate region G1 and the second gate region G2 are separately connected to the gate pin G, which is not shown in the figure.

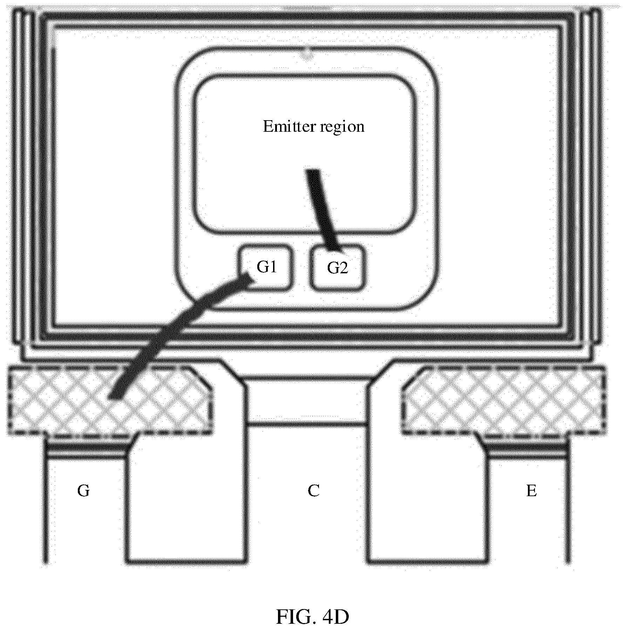

FIG. 4D is a schematic diagram of a connection between two gate regions included in another single IGBT according to an embodiment of this application.

In the IGBT provided in this embodiment, the first gate region G1 is connected to a gate pin G, and the second gate region G2 is connected to the emitter region 10.

For example, when the gate pin G is connected to a driving pulse signal of +15 V, the first gate region G1 works. However, the second gate region G2 is connected to the emitter region 10. Therefore, the second gate region G2 does not work (to be specific, G1 = 15 V, and G2 = 0 V). In this case, a conductive channel through which an injected electron passes is formed around only the first gate region G1. In comparison with a layout in FIG. 4C, a quantity of conductive channels through which the injected electron passes is reduced by one. Consequently, efficiency of injecting an electron by the emitter is reduced by half. Therefore, an on-state voltage drop Vcesat between the collector and the emitter becomes larger, and the switching loss corresponding to the IGBT is reduced. This type of IGBT is applicable to a scenario in which there is a high switching frequency. Because there is a large quantity of switching times, the switching loss of the IGBT is small. Therefore, overall power consumption is reduced.

It should be understood that, when the plurality of gate regions are disposed in this embodiment of this application, a specific wire seating manner is not limited. For example, wire seating may be performed based on a specific application scenario. It can be learned from the foregoing analysis that a value of Vcesat of the IGBT can be adjusted through packaging and wire seating.

FIG. 4C and 4D describe a wire seating layout of a single IGBT tube, namely, a single transistor above. Similarly, the following describes a case in which when a package includes a plurality of IGBT tubes, namely, one IGBT group, that one IGBT includes a plurality of gate regions is used as an example to describe a wire seating layout corresponding to the IGBT group.

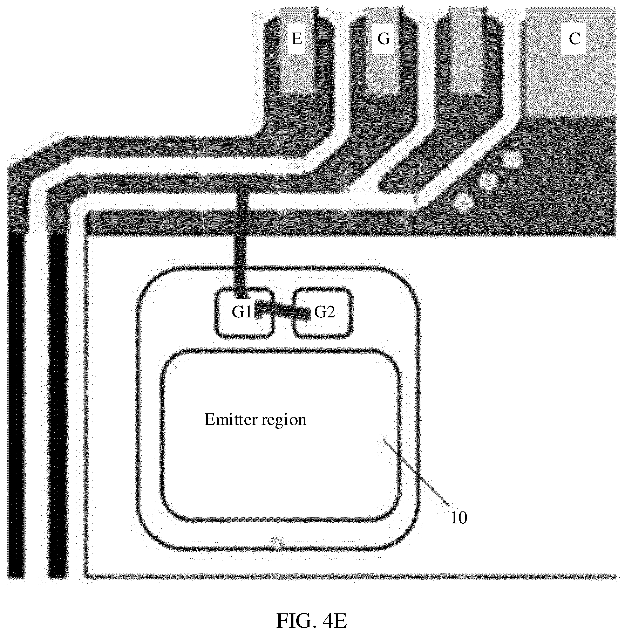

FIG. 4E is a schematic diagram of a connection between two gate regions included in an IGBT group according to an embodiment of this application.

In this embodiment, the first gate region G1 and the second gate region G2 each are connected to the gate pin. In other words, no gate region is connected to the emitter region 10.

In a specific implementation, the first gate region G1 and the second gate region G2 are short-circuited together and are connected to the gate pin G. It can be learned from the figure that, when the first gate region G1 and the second gate region G2 are short-circuited together and then are connected to the gate pin G, there is a small quantity of connection wires, to avoid complex wiring caused when too many wires are used to connect the gate pin G. In a specific implementation, the first gate region G1 and the second gate region G2 may be short-circuited together through a metal interconnection.

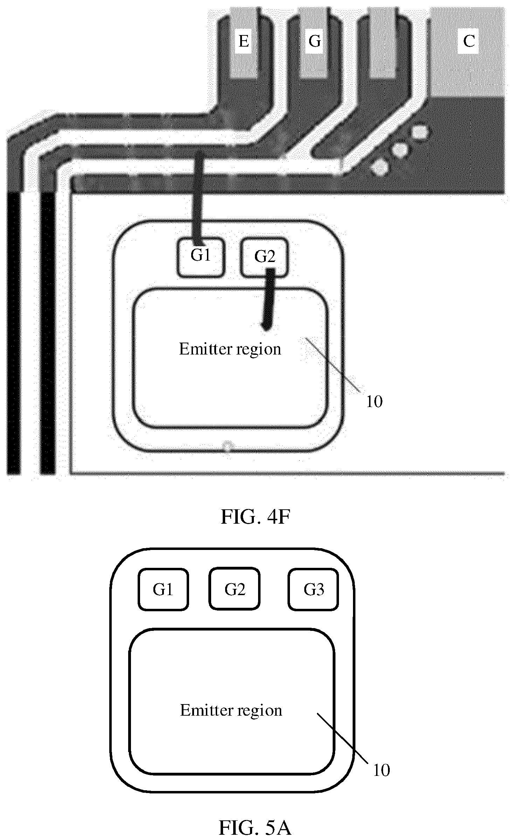

FIG. 4F is a schematic diagram of a connection between two gate regions included in another IGBT group according to an embodiment of this application.

In the IGBT provided in this embodiment, the first gate region G1 is connected to a gate pin G, and the second gate region G2 is connected to the emitter region 10.

For advantages corresponding to FIG. 4E and FIG. 4F, refer to descriptions in FIG. 4C and FIG. 4D. Details are not described herein again.

The following describes an implementation in which the IGBT includes three gate regions.

FIG. 5A is a schematic diagram of a layout of three gate regions included in an IGBT according to an embodiment of this application.

The IGBT provided in this embodiment includes a plurality of gate regions, and specifically includes the following three gate regions: a first gate region G1, a second gate region G2, and a third gate region G3.

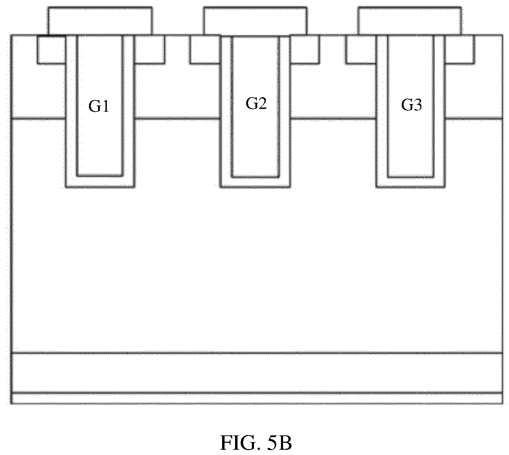

FIG. 5B is a schematic diagram of a cell structure corresponding to FIG. 5A.

In this embodiment of this application, that the IGBT is of a trench gate IGBT structure is used as an example. FIG. 5B is a schematic diagram of a cell of a trench gate IGBT including three gate regions G1, G2, and G3.

The following describes a specific wire seating manner with reference to an example in which a single IGBT includes three gate regions.

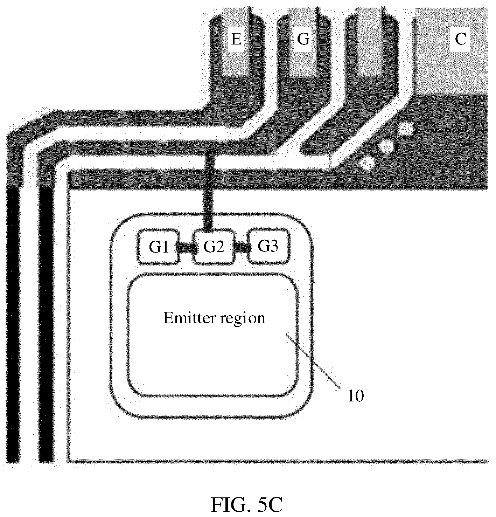

FIG. 5C is a schematic diagram of a connection among three gate regions included in an IGBT according to an embodiment of this application.

In the IGBT provided in this embodiment, the three gate regions each are connected to the gate pin. To be specific, the first gate region G1, the second gate region G2, and the third gate region G3 are short-circuited together and are connected to the gate pin G. The first gate region G1, the second gate region G2, and the third gate region G3 may be short-circuited together by using a metal connection wire.

In addition, there is another manner in which the three gate regions each are connected to the gate pin G. To be specific, the first gate region G1, the second gate region G2, and the third gate region G3 are separately connected to the gate pin G. In this case, there are correspondingly three long metal wires. However, the first gate region G1, the second gate region G2, and the third gate region G3 do not need to be connected to each other.

When the gate pin G is connected to a driving signal of +15 V, the first gate region G1, the second gate region G2, and the third gate region G3 simultaneously work (to be specific, G1 = G2 = G3 = 15 V). To be specific, a conductive channel through which an injected electron from the emitter passes is formed around each of the first gate region G1, the second gate region G2, and the third gate region G3, so that an on-state voltage drop Vcesat between a collector and the emitter is reduced, and the conduction loss is correspondingly reduced. This type of IGBT is usually applicable to a low frequency application.

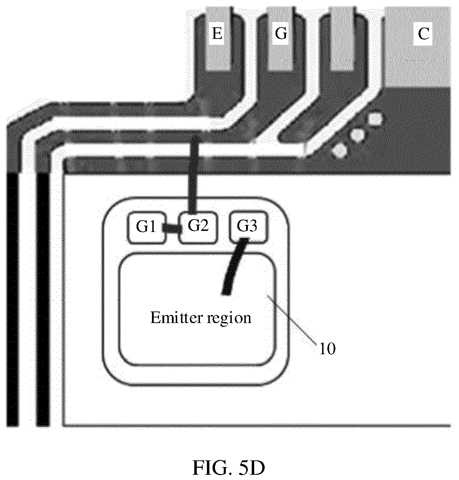

FIG. 5D is a schematic diagram of a connection among three gate regions included in another IGBT according to an embodiment of this application.

The following describes a case in which two of the three gate regions are connected to the gate pin.

Two of the first gate region, the second gate region, and the third gate region are short-circuited together and are connected to the gate pin, and the other gate region is connected to the emitter region. In other words, any two of the three gate regions may be connected together and then are connected to the gate pin, and the other gate region is connected to the emitter region. FIG. 5D shows only one implementation. Because the first gate region G1 and the second gate region G2 are close to each other, for simple wiring, the first gate region G1 and the second gate region G2 may be short-circuited together and then are connected to the gate pin G. The third gate region G3 is connected to the emitter region 10.

When the gate pin G is connected to a driving signal of +15 V, both the first gate region G1 and the second gate region G2 work. To be specific, a conductive channel through which an injected electron from the emitter passes is formed around each of the first gate region G1 and the second gate region G2. However, G3 is connected to the emitter region 10. Therefore, G3 does not work (to be specific, G1 = G2 = 15 V, and G3 = 0 V). In comparison with FIG. 5C, efficiency of injecting an electron by the emitter is reduced. In this case, an on-state voltage drop Vcesat between the collector and the emitter becomes larger, and a corresponding switching loss is reduced. The IGBT is usually applicable to a medium-frequency application and a high-frequency application.

In addition, the first gate region G1 and the third gate region G3 may alternatively be short-circuited together and then are connected to the gate pin G. The second gate region G2 is connected to the emitter region 10. Another case is similar. Details are not described herein.

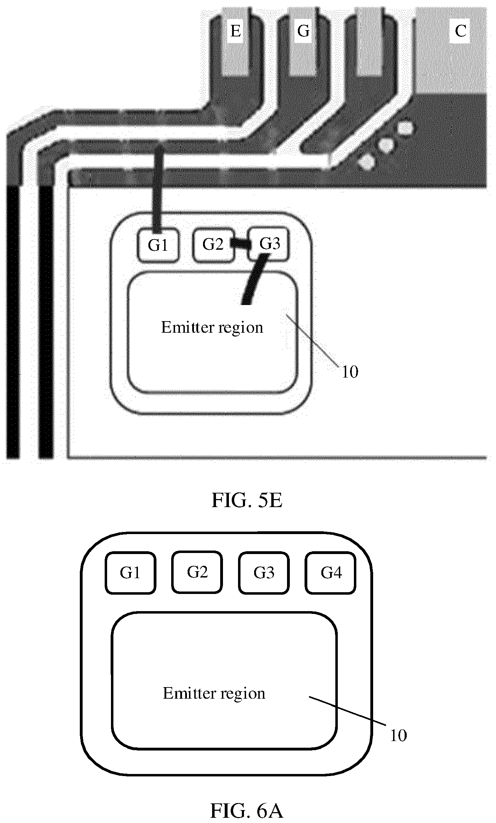

FIG. 5E is a schematic diagram of a connection among three gate regions included in another IGBT according to an embodiment of this application.

The following describes an implementation in which any one of the three gate regions is connected to the gate pin and the other two gate regions are connected to the emitter region. To be specific, two of the first gate region, the second gate region, and the third gate region are short-circuited together and are connected to the emitter region, and the other gate region is connected to the gate pin.

In FIG. 5E, the first gate region G1 is connected to the gate pin G, and the second gate region G2 and the third gate region G3 are short-circuited together and are connected to the emitter region 10.

Similarly, FIG. 5E is only a schematic diagram. Because the second gate region G2 and the third gate region G3 are close to each other, for simple wiring, the second gate region G2 and the third gate region G3 may be short-circuited together and are connected to the emitter region 10. In addition, the second gate region G2 and the third gate region G3 may alternatively be separately connected to the emitter region 10. This is not specifically limited in this embodiment of this application.

When the gate pin G is connected to a driving signal of +15 V, the first gate region G1 works. However, the second gate region G2 and the third gate region G3 are connected to the emitter region 10. Therefore, the second gate region G2 and the third gate region G3 do not work (to be specific, G1 = 15 V, and G2 = G3 = 0 V). In this case, a conductive channel through which an injected electron from the emitter passes is formed around only the first gate region G1. In comparison with FIG. 5D, efficiency of injecting an electron by the emitter into the collector is further reduced. In this case, an on-state voltage drop Vcesat between the collector and the emitter becomes larger, and a corresponding switching loss becomes smaller. In comparison with FIG. 5D, this type of IGBT is applicable to a higher-frequency application.

Values of Vcesat of IGBTs corresponding to the three layouts in FIG. 5C, FIG. 5D, and FIG. 5E are sequentially reduced, and a person skilled in the art may select and set one of the three layouts based on an actual requirement.

The foregoing describes an implementation in which the IGBT includes three gate regions, and the following describes an implementation in which the IGBT includes four gate regions with reference to the accompanying drawings.

FIG. 6A is a schematic diagram of a layout of four gate regions included in an IGBT according to an embodiment of this application.

The IGBT provided in this embodiment includes four gate regions, to be specific, includes the following four gate regions: a first gate region G1, a second gate region G2, a third gate region G3, and a fourth gate region G4.

A person skilled in the art may select, based on a requirement, at least one of the four gate regions, and connect the selected gate region and the gate pin, and the other gate regions are connected to the emitter region 10.

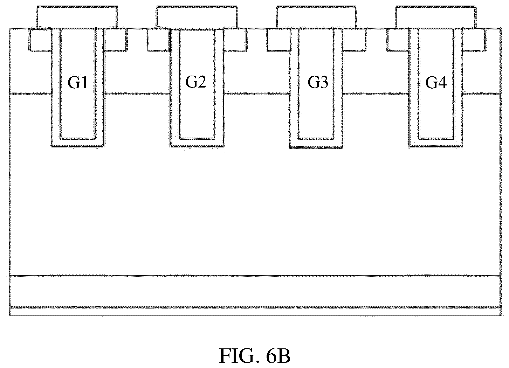

FIG. 6B is a schematic diagram of a cell structure corresponding to FIG. 6A.

In this embodiment of this application, that the IGBT is of a trench gate IGBT structure is used as an example. FIG. 6B is a schematic diagram of a cell of a trench gate IGBT including four gate regions G1, G2, G3, and G4.

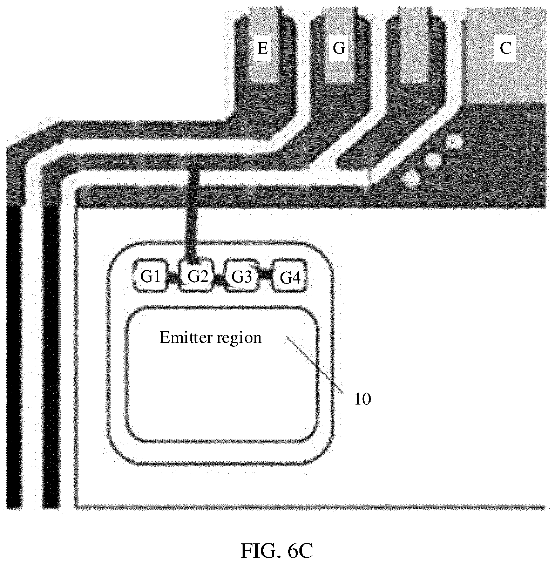

FIG. 6C is a schematic diagram of a connection among four gate regions included in an IGBT according to an embodiment of this application.

This embodiment describes a case in which the four gate regions each are connected to the gate pin G. In other words, no gate region is connected to the emitter region 10.

In a possible implementation, the first gate region G1, the second gate region G2, the third gate region G3, and the fourth gate region G4 are short-circuited together and are connected to the gate pin G. In this connection manner, it is easy to implement wire seating, and a process is simple.

In another implementation, the first gate region G1, the second gate region G2, the third gate region G3, and the fourth gate region G4 are separately connected to the gate pin G, and the four gate regions do not need to be short-circuited with each other.

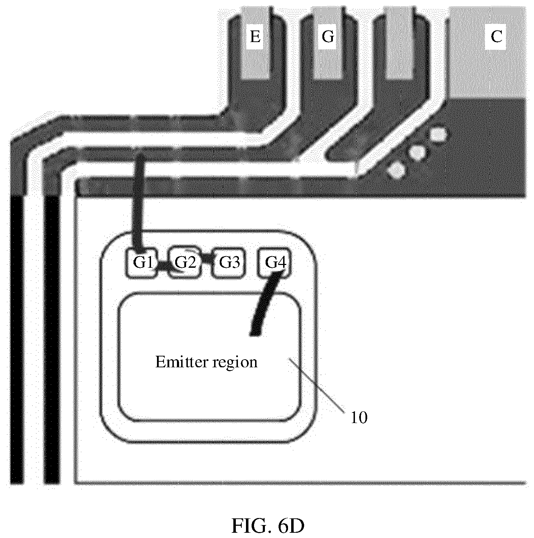

FIG. 6D is a schematic diagram of a connection among four gate regions included in another IGBT according to an embodiment of this application.

This embodiment describes a case in which three of the four gate regions are connected to the gate pin. To be specific, three of the first gate region G1, the second gate region G2, the third gate region G3, and the fourth gate region G4 are short-circuited together and are connected to the gate pin G, and the other gate region is connected to the emitter region 10.

This embodiment of this application provides a feasible implementation in which the first gate region G1, the second gate region G2, and the third gate region G3 are short-circuited together and are connected to the gate pin G, and the fourth gate region G4 is connected to the emitter region 10. Because the first gate region G1, the second gate region G2, and the third gate region G3 are close to each other, wiring is simple when the first gate region G1, the second gate region G2, and the third gate region G3 are shorted together and then are connected to the gate pin G. In this embodiment of this application, that the three gate regions are short-circuited together and are connected to the gate pin G through the first gate region G1 is used as an example for description. It should be understood that the three gate regions may alternatively be connected to the gate pin G through the second gate region G2 or the third gate region G3. This is not specifically limited in this embodiment of this application. Another embodiment is similar.

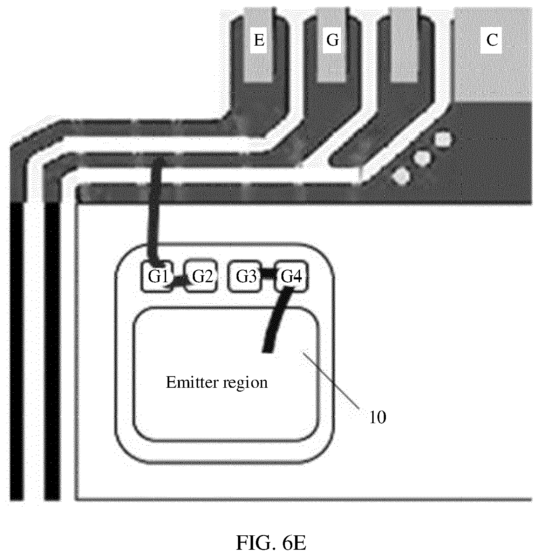

FIG. 6E is a schematic diagram of a connection among four gate regions included in another IGBT according to an embodiment of this application.

The following describes a case in which two of the four gate regions are connected to the gate pin and the other two gate regions are connected to the emitter region. To be specific, two of the first gate region, the second gate region, the third gate region, and the fourth gate region are short-circuited together and are connected to the gate pin, and the other two gate regions are connected to the emitter region.

In FIG. 6E, the first gate region G1 and the second gate region G2 are short-circuited together and are connected to the gate pin G, and specifically, are connected to the gate pin G through the first gate region G1. The third gate region G3 and the fourth gate region G4 are short-circuited together and are connected to the emitter region 10, and specifically, are connected to the emitter region 10 through the fourth gate region G4. In addition, alternatively, the third gate region G3 and the fourth gate region G4 may be short-circuited together and are connected to G, and the first gate region G1 and the second gate region G2 may be short-circuited together and are connected to the emitter region 10. This is not specifically limited in this embodiment of this application. Because the first gate region G1 and the second gate region G2 are close to each other, wiring is simple when the first gate region G1 and the second gate region G2 are short-circuited together. Similarly, wiring is simple when the third gate region G3 and the fourth gate region G4 are short-circuited together.

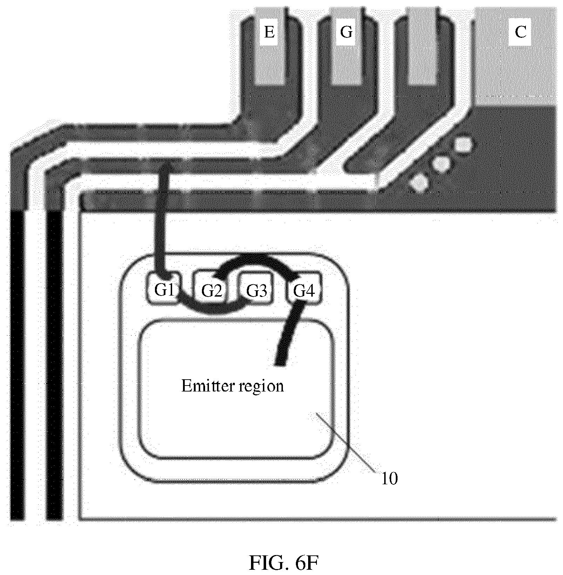

FIG. 6F is a schematic diagram of a connection among four gate regions included in another IGBT according to an embodiment of this application.

A similarity between FIG. 6F and FIG. 6E is that two gate regions are connected to the gate pin, and two gate regions are connected to the emitter region, and a difference is that specific connection relationships are different.

In FIG. 6F, the first gate region G1 and the third gate region G3 are short-circuited together and are connected to the gate pin G, and the second gate region G2 and the fourth gate region G4 are short-circuited together and are connected to the emitter region 10. A difference between this connection manner and that in FIG. 6E is that the gate regions are connected in a crossing manner. A specific crossing manner is not limited in this embodiment of this application. Wire seating of one gate region and wire seating of another gate region may cross, or wire seating of one gate region and wire seating of a plurality of gate regions may cross. When there are a large quantity of gate regions, one-to-one crossing or one-to-many crossing may exist.

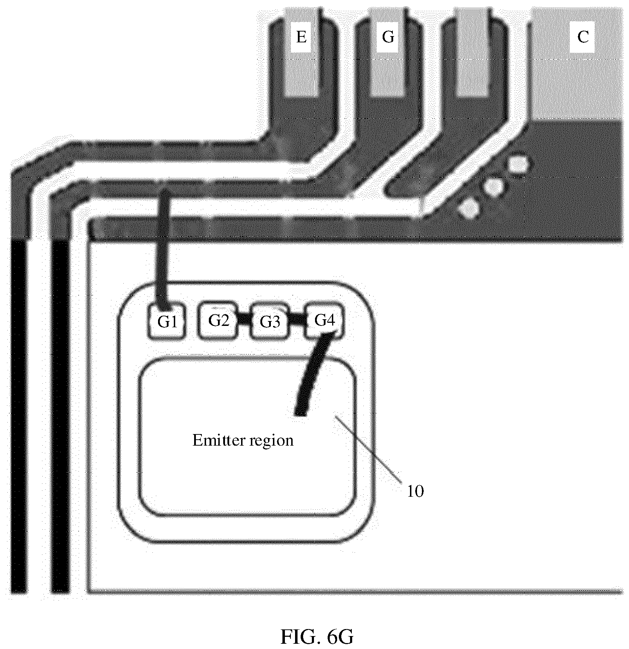

FIG. 6G is a schematic diagram of a connection among four gate regions included in another IGBT according to an embodiment of this application.

This embodiment describes a case in which three of the four gate regions are connected to the emitter pin. Three of the first gate region, the second gate region, the third gate region, and the fourth gate region are short-circuited together and are connected to the emitter region, and the other gate region is connected to the gate pin.

As shown in FIG. 6G, the first gate region G1 is connected to the gate pin G, and the second gate region G2, the third gate region G3, and the fourth gate region G4 are short-circuited together and are connected to the emitter region 10. Specifically, the second gate region G2, the third gate region G3, and the fourth gate region G4 are short-circuited together and are connected to the emitter region 10 through the fourth gate region G4.

Values of on-state voltage drops Vcesat between collectors and emitters of the IGBTs corresponding to the four layouts in FIG. 6C, FIG. 6D, FIG. 6E, and FIG. 6F are sequentially reduced, and a person skilled in the art may select and set one of four layouts based on an actual requirement. For a specific principle, refer to the descriptions of the foregoing embodiment of the two gate regions and the three gate regions. Details are not described herein again.

Based on the IGBT provided in the foregoing embodiment, an embodiment of this application provides an IGBT group. A difference between the IGBT group and the IGBT is that the IGBT group includes a plurality of IGBT tubes. Any one or more IGBT tubes may be the architectures of the IGBTs described in the foregoing embodiment. A specific advantage is similar. Only an implementation of the IGBT group is described herein. For a specific working principle, refer to the foregoing description of a single IGBT tube. Details are not described herein again.

An embodiment of this application further provides an IGBT group, including a semiconductor chip. The semiconductor chip includes a plurality of IGBTs; a gate pin, an emitter pin, and a collector pin of each IGBT are disposed around the semiconductor chip; an emitter region and a gate region of each IGBT are disposed on the semiconductor chip; at least one IGBT includes a plurality of gate regions; at least one of the plurality of gate regions is connected to a gate pin of a corresponding IGBT; and the other gate regions in the plurality of gate regions are connected to an emitter region of the corresponding IGBT.

For the IGBT group provided in this embodiment of this application, whether each IGBT tube in the IGBT group includes a plurality of gate regions is not limited. At least one IGBT may include a plurality of gate regions, or the plurality of IGBTs each may include a plurality of gate regions. In addition, for more flexible use, each IGBT in the IGBT group may include a plurality of gate regions.

In a possible implementation, for a first IGBT including a plurality of gate regions, the plurality of gate regions are n gate regions, where n is an integer greater than or equal to 2; and a gate regions are short-circuited together and are connected to a gate pin of the first IGBT, and b gate regions are short-circuited together and are connected to an emitter region of the first IGBT, where a + b = n.

In another implementation, for a first IGBT including a plurality of gate regions, the plurality of gate regions are n gate regions, where n is an integer greater than or equal to 2; and a gate regions are separately connected to a gate pin of the first IGBT, and b gate regions are separately connected to an emitter region of the first IGBT, where a + b = n.

A conduction loss of the first IGBT is positively correlated with a, and a switching loss of the first IGBT is positively correlated with b.

Based on the IGBT or the IGBT group provided in the foregoing embodiments, an embodiment of this application further provides a power converter, including the IGBT described in the foregoing embodiments or including the foregoing described IGBT group. The power converter provided in this embodiment of this application may be a rectifier, an inverter, or a DC/DC converter. A specific application scenario is not specifically limited, and any power converter including an IGBT device may be used.

The IGBT or the IGBT group included in the power converter includes a plurality of gate regions, at least one of the plurality of gate regions is connected to a gate pin, and the other gate regions in the plurality of gate regions are connected to an emitter region. Because the IGBT provided in this embodiment of this application includes a plurality of gate regions, a quantity of gate regions connected to a gate pin of an IGBT chip may be selected based on an actual requirement. Electrical performance of the IGBT varies with the quantity of gate regions connected to the gate pin. For the IGBT having the plurality of gate regions, when more gate regions are connected to the gate pin, a conductive channel is formed around all gate regions connected to the gate pin, and an injected electron from an emitter passes through the conductive channel. In other words, a quantity of conductive channels corresponding to the injected electron from the emitter is increased, so that an on-state voltage drop between a collector and the emitter is reduced. Therefore, a conduction loss of the IGBT can be reduced. An IGBT with a small conduction loss may be applied to a scenario in which there is a low switching frequency. On the contrary, when a small quantity of gate regions are connected to the gate pin, a smaller quantity of conductive channels are formed. A smaller quantity of conductive channels through which an injected electron passes leads to lower efficiency of injecting an electron by an emitter. Consequently, a corresponding on-state voltage drop between a collector and the emitter becomes larger. Therefore, a switching loss of the IGBT is reduced, but a conduction loss is increased. This type of IGBT is applicable to a scenario in which a high switching frequency is required. Therefore, a structure of the IGBT in the power converter can be selected based on a specific application scenario.

It should be understood that, in this application, "at least one" means one or more, and "a plurality of" means two or more. The term "and/or" is used to describe an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one (piece) of a, b, or c may represent a, b, c, "a and b", "a and c", "b and c", or "a, b, and c", where a, b, and c may be singular or plural.

The foregoing descriptions are merely example embodiments of this application, and are not intended to limit this application in any form. Although the embodiments of this application are disclosed above, the embodiments are not intended to limit this application. By using the method and the technical content disclosed above, any person of ordinary skill in the art can make a plurality of possible changes and modifications on the technical solutions of this application, or amend the technical solutions thereof to be embodiments with equal effects through equivalent variations without departing from the protection scope of the technical solutions of this application. Therefore, any simple amendments, equivalent variations, and modifications made on the above embodiments according to the technical essence of this application without departing from the content of the technical solutions of this application shall fall within the protection scope of the technical solutions of this application.

## Claims

1. An insulated gate bipolar field-effect transistor IGBT, comprising a semiconductor chip, a gate pin disposed around the semiconductor chip, and an emitter region and n gate regions that are disposed on the semiconductor chip, wherein n is an integer greater than or equal to 2;
a gate regions in the n gate regions are connected to the gate pin, wherein a is greater than or equal to 1 and less than or equal to n;
n-a gate regions in the n gate regions are connected to the emitter region; and
when there is a different quantity a of gate regions connected to the gate pin, the IGBT is correspondingly applicable to a scenario in which there is a different switching frequency and loss.

2. The IGBT according to claim 1, wherein the a gate regions are short-circuited together and are connected to the gate pin; and
the n-a gate regions are short-circuited together and are connected to the emitter region.

3. The IGBT according to claim 1, wherein the a gate regions are separately connected to the gate pin; and the n-a gate regions are separately connected to the emitter region.

4. The IGBT according to any one of claims 1 to 3, wherein a conduction loss of the IGBT is positively correlated with a, a switching loss of the IGBT is positively correlated with n-a, and a switching frequency of the IGBT is negatively correlated with a.

5. The IGBT according to any one of claims 1 to 4, wherein the n gate regions comprise the following two gate regions: a first gate region and a second gate region; and
the first gate region and the second gate region are short-circuited together and are connected to the gate pin; or
the first gate region is connected to the gate pin, and the second gate region is connected to the emitter region.

6. The IGBT according to any one of claims 1 to 4, wherein the n gate regions comprise the following three gate regions: a first gate region, a second gate region, and a third gate region; and
the first gate region, the second gate region, and the third gate region are short-circuited together and are connected to the gate pin; or
two of the first gate region, the second gate region, and the third gate region are short-circuited together and are connected to the gate pin, and the other gate region is connected to the emitter region; or
two of the first gate region, the second gate region, and the third gate region are short-circuited together and are connected to the emitter region, and the other gate region is connected to the gate pin.

7. The IGBT according to any one of claims 1 to 4, wherein the n gate regions comprise the following four gate regions: a first gate region, a second gate region, a third gate region, and a fourth gate region; and
the first gate region, the second gate region, the third gate region, and the fourth gate region are short-circuited together and are connected to the gate pin; or
three of the first gate region, the second gate region, the third gate region, and the fourth gate region are short-circuited together and are connected to the gate pin, and the other gate region is connected to the emitter region; or
two of the first gate region, the second gate region, the third gate region, and the fourth gate region are short-circuited together and are connected to the gate pin, and the other two gate regions are connected to the emitter region; or
three of the first gate region, the second gate region, the third gate region, and the fourth gate region are short-circuited together and are connected to the emitter region, and the other gate region is connected to the gate pin.

8. A power converter, comprising the IGBT according to any one of claims 1 to 7.
